# EUROPEAN PATENT APPLICATION

(11) **EP 4 712 708 A1**
(43) Date of publication of application: **18.03.2026**
(21) Application number: 24215990.3
(22) Date of filing: 28.11.2024
(51) Int. Cl.: H05K 3/32, H05K 3/22, H05K 1/02, H05K 3/38

(54) **JUNCTION BLOCK FOR DISTRIBUTING HIGH-CURRENT POWER**

(30) Priority: 12.09.2024 KR 20240124832
(71) Applicant: Kyungshin Corp., Incheon 21999 (KR)
(72) Inventor: PARK, Kyung Jeon, 21986 Incheon (KR)
(74) Representative: Michalski Hüttermann & Partner Patentanwälte mbB

(57) **Abstract**

The present invention discloses a junction block for distributing high-current power. The disclosed junction block for distributing high-current power includes a main printed circuit board, and a jumping busbar exposed to the outside of the main printed circuit board and configured to electrically connect circuit areas spaced apart from each other in the main printed circuit board.

## Description

### CROSS-REFERENCE TO RELATED APPLICATION

This application claims priority to and the benefit of Korean Patent Application No. 10-2024-0124832, filed on September 12, 2024, the disclosure of which is incorporated herein by reference in its entirety.

### BACKGROUND

### 1. Field of the Invention

The present invention relates to a junction block for distributing high-current power, and more particularly, to a junction block for distributing high-current power in which different circuit areas of a printed circuit board are jump-power-connected with a jumping busbar exposed from the printed circuit board to allow a flow of high current and increase heat dissipation efficiency through the exposed jumping busbar, and eliminate a need for a separate component other than the jumping busbar for jump power connection, thereby improving the assemblability of the printed circuit board assembly and reducing manufacturing costs.

### 2. Discussion of Related Art

A vehicle uses a battery as a power source to drive various electronic components such as a spark plug embedded in an engine, and a vehicle junction block for distributing currents supplied from the battery to these electronic components.

An existing junction block includes a current terminal from which power is supplied, a busbar which distributes currents supplied from the current terminal, and a plurality of fuses connected to the busbar to supply currents to desired electronic components. Here, the busbar is formed in the form of a plate-shaped conductor and is fixed to the current terminal and a housing through bolts. In addition, the fuse is detachably fixed to the busbar from the outside.

As a related art, Korean Patent Registration No. 10-1734683 (registration date: May 2, 2017, title: vehicle power distribution device) has been proposed.

The technical configuration is background technology for helping understanding of the present invention and is not intended to represent related art that is widely known in the art to which the present invention belongs.

### SUMMARY OF THE INVENTION

An existing junction block for distributing power of a vehicle is manufactured by stacking a lower printed circuit board and an upper circuit board, coupling a bus bar for allowing a high current to the upper circuit board, and electrically connecting a circuit pattern of the lower printed circuit board and a busbar of the upper circuit board using a fork terminal, and thus there are problems in that an assembly process is complex, productivity is low, and manufacturing costs increase.

Therefore, there is a need to solve such problems.

The present invention is directed to providing a junction block for distributing high-current power in which different circuit areas of a printed circuit board are electrically jump-power-connected with a jumping busbar exposed from the printed circuit board to allow a flow of high current and increase heat dissipation efficiency through the exposed jumping busbar, and eliminate a need for a separate component other than the jumping busbar for jump power connection, thereby improving the assemblability of the printed circuit board assembly and reducing manufacturing costs.

According to an aspect of the present invention, there is provided a junction block for distributing high-current power, the junction block including a main printed circuit board, a jumping busbar exposed to the outside of the main printed circuit board and configured to electrically connect circuit areas spaced apart from each other in the main printed circuit board, and a waterproof adhesive layer which is applied on an area in which the jumping busbar and the main printed circuit board are in contact and cured, maintains contact between the jumping busbar and the circuit area, and serves as a waterproofing layer.

The main printed circuit board may electrically connect a sub-printed circuit board disposed to face the main printed circuit board.

The main printed circuit board may include a first circuit area which receives power from the outside and in which a first circuit pattern is patterned, a second circuit area which is spaced apart from the first circuit area and receives power to control a voltage and a current according to set capacity and then transmit and guide the voltage and current to the outside and in which a second circuit pattern is patterned, and a third circuit area which is spaced apart from the first circuit area and the second circuit area and receives power from the first circuit area or the second circuit area to supply the power to a mounted electronic element and in which a third circuit pattern is patterned.

The second circuit area may receive power from the first circuit area or the third circuit area.

The jumping busbar may include an inner busbar configured to jump-connect the first circuit pattern and the second circuit pattern, and an outer busbar configured to jump-connect the first circuit pattern and the third circuit pattern or the second circuit pattern and the third circuit pattern.

The main printed circuit board has exposure grooves formed to expose portions of the first circuit pattern, the second circuit pattern, and the third circuit pattern which are embedded and patterned.

The inner busbar may be in contact with the first circuit pattern and the second circuit pattern through the exposure grooves.

The outer busbar may be in contact with the first circuit pattern and the third circuit pattern or the second circuit pattern and the third circuit pattern through the exposure grooves.

An insertion hole may be formed to pass through the main printed circuit board and a corresponding circuit pattern.

At least one of the inner busbar and the outer busbar may include an electrical connection bar made of a bar-shaped conductor, a bending contact bar bent from both sides of the electrical connection bar in an axial direction and inserted into the insertion hole to be in contact with the corresponding circuit pattern, and a catch portion formed on the bending contact bar and in contact with the circuit pattern corresponding to an upper edge of the insertion hole to maintain an interval between the electrical connection bar and the main printed circuit board.

At least one of the inner busbar and the outer busbar may include an electrical connection bar made of a bar-shaped conductor, an edge bending bars bent from both sides of the electrical connection bar in an axial direction, and a surface contact bar bent form each edge bending bar to be parallel to the main printed circuit board to be in surface contact with the circuit pattern.

### BRIEF DESCRIPTION OF THE DRAWINGS

The above and other objects, features and advantages of the present invention will become more apparent to those of ordinary skill in the art by describing exemplary embodiments thereof in detail with reference to the accompanying drawings, in which:
FIG. 1 is a perspective view of a junction block for distributing high-current power according to one embodiment of the present invention;
FIG. 2 is a perspective view of a main part of the junction block for distributing high-current power according to one embodiment of the present invention;
FIG. 3 is a plan view of the junction block for distributing high-current power according to one embodiment of the present invention;
FIG. 4 is an exploded perspective view of the main part of the junction block for distributing high-current power according to one embodiment of the present invention;
FIG. 5 is a cross-sectional view of the junction block for distributing high-current power according to one embodiment of the present invention;
FIG. 6 is a perspective view of a junction block for distributing high-current power according to another embodiment of the present invention;
FIG. 7 is a perspective view of a main part of the junction block for distributing high-current power according to another embodiment of the present invention;
FIG. 8 is a plan view of the junction block for distributing high-current power according to another embodiment of the present invention;
FIG. 9 is an exploded perspective view of the main part of the junction block for distributing high-current power according to another embodiment of the present invention; and
FIG. 10 is a cross-sectional view of the junction block for distributing high-current power according to another embodiment of the present invention.

### DETAILED DESCRIPTION OF EXEMPLARY EMBODIMENTS

Hereinafter, embodiments of a junction block for distributing high-current power according to the present invention will be described with reference to the accompanying drawings. The accompanying drawings are not necessarily to scale and in some instances, proportions may have been exaggerated in order to clearly illustrate features of the embodiments. Further, the terms to be described below are terms defined in consideration of functions in the present invention and thus may vary according to intentions or customs of users and operators. Accordingly, such terms should be defined based on the content throughout the specification.

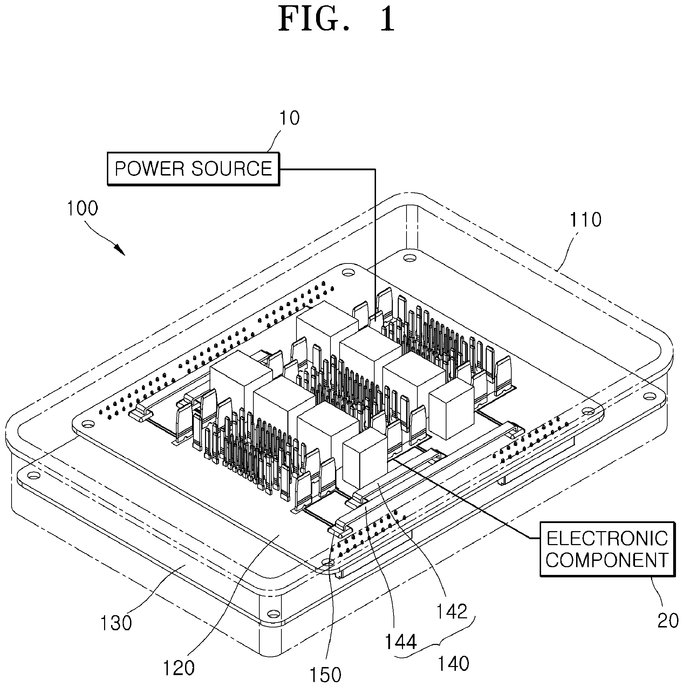

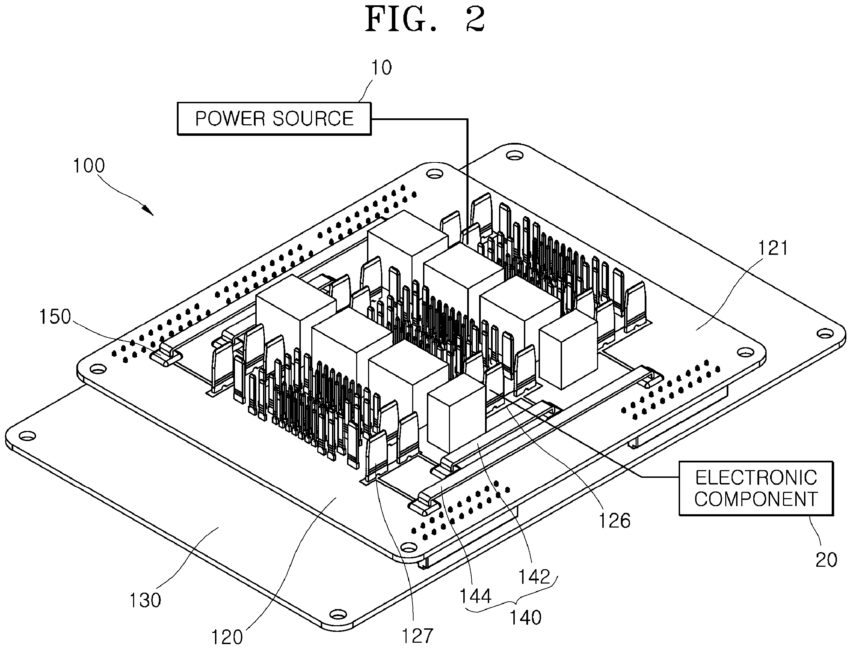

FIG. 1 is a perspective view of a junction block for distributing high-current power according to one embodiment of the present invention. FIG. 2 is a perspective view of a main part of the junction block for distributing high-current power according to one embodiment of the present invention.

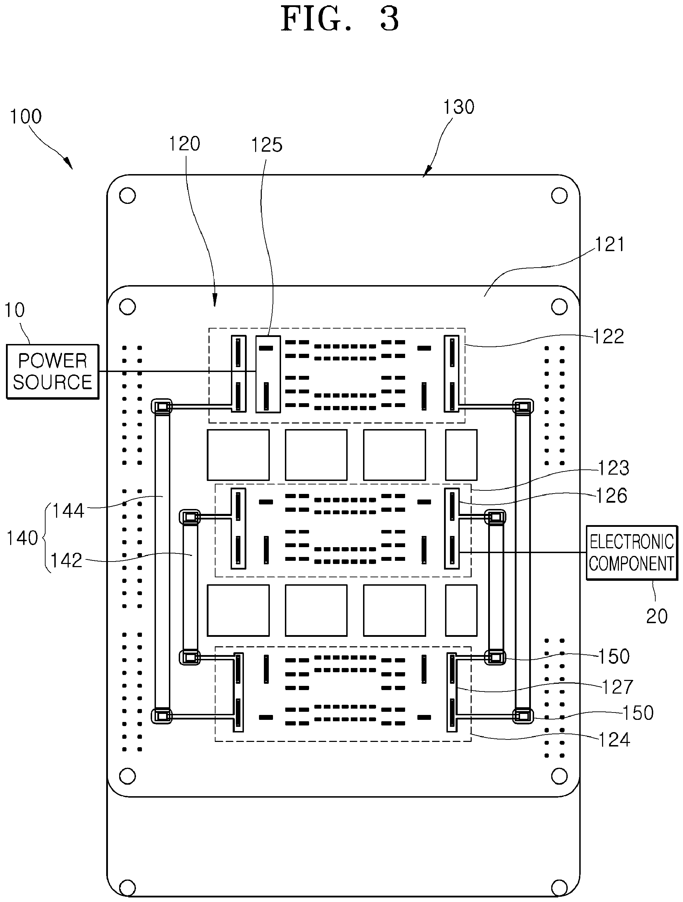

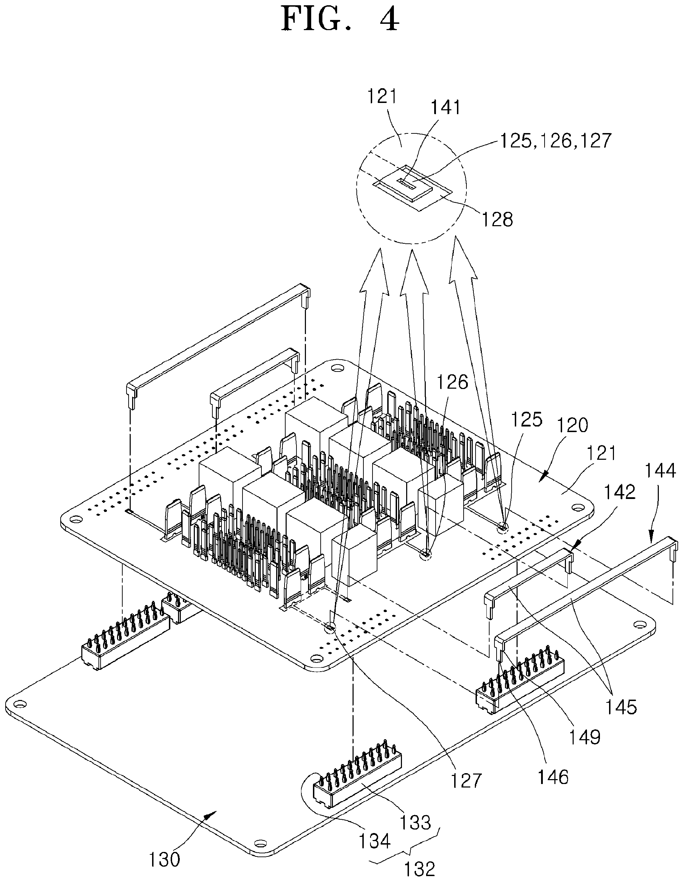

FIG. 3 is a plan view of the junction block for distributing high-current power according to one embodiment of the present invention. FIG. 4 is an exploded perspective view of the main part of the junction block for distributing high-current power according to one embodiment of the present invention.

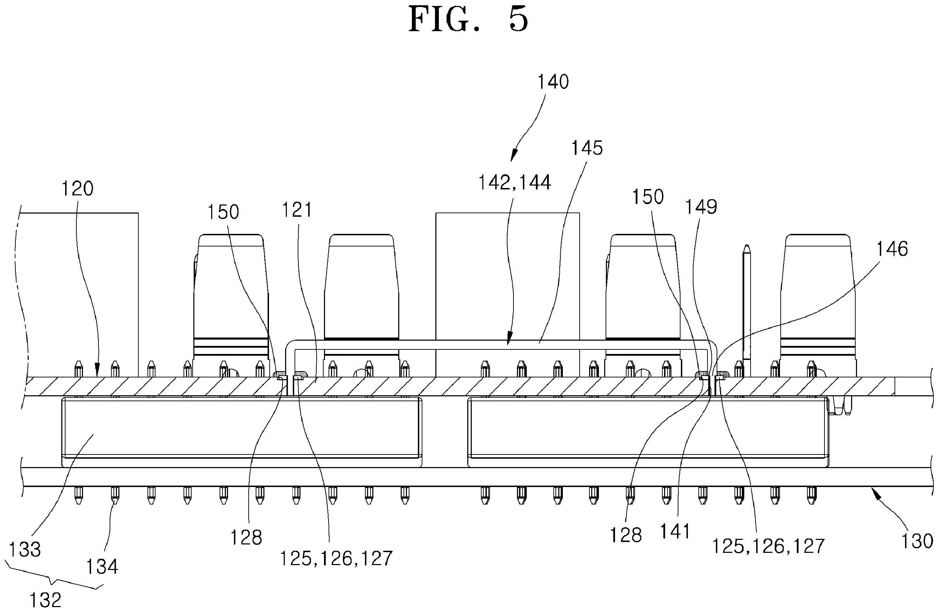

FIG. 5 is a cross-sectional view of the junction block for distributing high-current power according to one embodiment of the present invention.

Referring to FIGS. 1 to 5, a junction block 100 for distributing high-current power according to one embodiment of the present invention includes a main printed circuit board 120, a sub-printed circuit board 130, a jumping busbar 140, and a waterproof adhesive layer 150.

The main printed circuit board 120 serves to receive power and signals from a power source 10 such as a battery, process the power and the signals internally, and then distribute the power and the signals to electronic components 20 of a vehicle.

In this case, the junction block 100 according to the present invention forms an exterior through a casing 110. The casing 110 may be transformed into any one of various shapes and may be formed with at least one side open.

Therefore, the casing 110 is provided with the main printed circuit board 120 and the sub-printed circuit board 130 stacked therein. For convenience, it is assumed that the main printed circuit board 120 is positioned on the sub-printed circuit board 130.

In addition, as the number of electronic components 20 of the vehicle increases, the main printed circuit board 120 with a set planar area may distribute power and signals to various electronic components 20 less smoothly.

Therefore, the sub-printed circuit board 130 is provided. The sub-printed circuit board 130 is electrically connected to the main printed circuit board 120 and serves to expand a space for distributing power and signals to a plurality of electronic components 20.

In this case, the shape of the main printed circuit board 120 is maintained by a base board 121 which is made of an insulating material.

In addition, the main printed circuit board 120 and the sub-printed circuit board 130 may be electrically connected by a socket 132.

The socket 132 includes a housing 133 and a contact pin 134.

The housing 133 is made of an insulating material, is fixedly installed on an upper surface of the sub-printed circuit board 130, and supports a lower surface of the main printed circuit board 120.

In particular, a plurality of housings 133 are provided along an edge of the sub-printed circuit board 130 to stably support the main printed circuit board 120. Accordingly, the main printed circuit board 120 and the sub-printed circuit board 130 may maintain a gap corresponding to a height of the housing 133.

Of course, the housing 133 may be fixedly installed on a lower surface of the main printed circuit board 120 and may be transformed into any one of various shapes.

In addition, at least one contact pin 134 is provided in each housing 133, is made of a conductor, and serves to electrically connect an electronic element mounted on the main printed circuit board 120 and an electronic element mounted on the sub-printed circuit board 130.

In addition, the jumping busbar 140 is exposed to the outside of the main printed circuit board 120 and serves to electrically connect circuit areas 122, 123, and 124 spaced apart from each other in the main printed circuit board 120.

In particular, the jumping busbar 140 is provided to be exposed at an upper surface of the main printed circuit board 120 opposite to the lower surface facing the sub-printed circuit board 130 to improve the heat dissipation performance of the main printed circuit board 120 and is formed to have a set cross-sectional volume to ensure that a high current flows smoothly.

Meanwhile, the main printed circuit board 120 is divided into a first circuit area 122, a second circuit area 123, and a third circuit area 124.

In this case, at least one of the first circuit area 122, the second circuit area 123, and the third circuit area 124 is electrically connected to a circuit pattern (not shown) of the sub-printed circuit board 130.

Specifically, the first circuit area 122 receives power from the outside. In the base board 121, a first circuit pattern 125 is patterned in the first circuit area 122. In this case, the baseboard 121 may include electronic elements such as terminals or fuses that are electrically connected to each other by the first circuit pattern 125 in the first circuit area 122.

The second circuit area 123 is disposed apart from the first circuit area 122 on the base board 121 and receives power to control a voltage and a current according to set capacity and then transmit and guide the voltage and the current to the outside, in particular, to the electronic component 20 of the vehicle. In the second circuit area 123, a second circuit pattern 126 is patterned on the base board 121 to receive power and signals.

In this case, the baseboard 121 may include electronic elements such as terminals or fuses that are electrically connected to each other by the second circuit pattern 126 in the second circuit area 123.

The third circuit area 124 is separated from the first circuit area 122 and the second circuit area 123 on the base board 121 and has a third circuit pattern 127 patterned on the base board 121 to receive power from the first circuit area 122 or the second circuit area 123 to supply power to the mounted electronic elements. Of course, the base board 121 may include electronic elements such as terminals or fuses that are electrically connected to each other by the third circuit pattern 127 in the third circuit area 124.

In particular, the second circuit area 123 may receive power from the first circuit area 122 or the third circuit area 124.

For convenience, it is assumed that the power source 10 is directly connected to the third circuit pattern 127 to apply power, and the first circuit area 122 and the second circuit area 123 receive power from the third circuit pattern 127 or the third circuit area 124.

Of course, the first circuit pattern 125 and the second circuit pattern 126, the first circuit pattern 125 and the third circuit pattern 127, the second circuit pattern 126 and the third circuit pattern 127, or the first circuit pattern 125, the second circuit pattern 126, and the third circuit pattern 127 may be directly connected to guide a current flow.

However, in this case, a copper thin plate forming the first circuit pattern 125, the second circuit pattern 126, and the third circuit pattern 127 may not smoothly guide a high current, and a fire may occur due to overload.

Therefore, the relatively voluminous jumping busbar 140 according to the present invention is applied. In addition, since the jumping busbar 140 is provided as a conductor to protrude outward from the main printed circuit board 120, the heat dissipation performance of the main printed circuit board 120 is improved. The jumping busbar 140 may be formed to have a cross section with any one of various shapes.

Meanwhile, the jumping busbar 140 may include an inner busbar 142 and an outer busbar 144.

The inner busbar 142 serves to jump-connect the first circuit pattern 125 and the second circuit pattern 126. In this case, in a state in which both edges of the inner busbar 142 are bent downward in an axial direction, the inner busbar 142 is electrically connected to the first circuit pattern 125 and the second circuit pattern 126.

In addition, the outer busbar 144 serves to jump-connect the first circuit pattern 125 and the third circuit pattern 127 or the second circuit pattern 126 and the third circuit pattern 127.

In a state in which both edges of the outer busbar 144 are bent downward in an axial direction, the outer busbar 144 is electrically connected to the first circuit pattern 125 and the third circuit pattern 127 or the second circuit pattern 126 and the third circuit pattern 127.

For convenience, the outer busbar 144 is illustrated as electrically connecting the first circuit pattern 125 and the third circuit pattern 127 in a state in which both edges of the outer busbar 144 are bent downward in the axial direction.

Therefore, an axial length of the outer busbar 144 may be formed to be greater than an axial length of the inner busbar 142.

Of course, the inner busbar 142 and the outer busbar 144 may made of a conductor and may be transformed into any one of various shapes.

Meanwhile, the jumping busbar 140 may be electrically connected to the first circuit pattern 125, the second circuit pattern 126, and the third circuit pattern 127 in various ways.

As an example, the main printed circuit board 120 has exposure grooves 128 to expose portions of the first circuit pattern 125, the second circuit pattern 126, and the third circuit pattern 127 that are embedded and patterned, that is, corresponding portions. In this case, the exposure groove 128 opens in an upward direction of the main printed circuit board 120 as viewed in the drawing.

In particular, since the exposure groove 128 is formed in a groove shape, the portions of the first circuit pattern 125, the second circuit pattern 126, and the third circuit pattern 127 exposed through the exposure grooves 128 are supported in contact with bottom surfaces of the exposure grooves 128 to prevent deformation.

The inner busbar 142 is directly mounted on the first circuit pattern 125 and the second circuit pattern 126 through the exposure grooves 128.

In addition, the outer busbar 144 is directly mounted on the first circuit pattern 125 and the third circuit pattern 127 or the second circuit pattern 126 and the third circuit pattern 127 through the exposure grooves 128.

In addition, portions of the inner busbar 142 mounted on the first circuit pattern 125 and the second circuit pattern 126 may be waterproofed.

Likewise, portions of the outer busbar 144 mounted on the first circuit pattern 125 and the third circuit pattern 127 or the second circuit pattern 126 and the third circuit pattern 127 may be waterproofed.

That is, after the inner busbar 142 is in contact with the first circuit pattern 125 and the second circuit pattern 126, the inner busbar 142 is waterproofed by maintaining contact with the waterproof adhesive layer 150.

In addition, after the outer busbar 144 comes in contact with the first circuit pattern 125 and the third circuit pattern 127 or the second circuit pattern 126 and the third circuit pattern 127, the outer busbar 144 is waterproofed by maintaining contact with the waterproof adhesive layer 150.

In this case, the waterproof adhesive layer 150 is formed by applying an adhesive on a corresponding area and then curing the adhesive. Therefore, the waterproof adhesive layer 150 bonds and fixes the inner busbar 142 and the main printed circuit board 120 and bonds and fixes the outer busbar 144 and the main printed circuit board 120.

Meanwhile, as an embodiment, an insertion hole 141 is formed to pass through the main printed circuit board 120 and the circuit pattern 125, 126, or 127.

That is, the base board 121 has a plurality of exposure grooves 128 formed to be open toward one side, and each exposure groove 128 exposes a portion of one of the first circuit pattern 125, the second circuit pattern 126, and the third circuit pattern 127.

In addition, the insertion hole 141 is formed to pass through the first circuit pattern 125 and the base board 121, is formed to pass through the second circuit pattern 126 and the base board 121, or is formed to pass through the third circuit pattern 127 and the base board 121.

In addition, an electrical connection bar 145, a bending contact bar 146, and a catch portion 149 may be formed in at least one of the inner busbar 142 and the outer busbar 144.

In this case, for convenience, the inner busbar 142 and the outer busbar 144 are illustrated as having the same shape.

The electrical connection bar 145 is made of a bar-shaped conductor.

In addition, the electrical connection bar 145 may be formed to have a certain length to jump-connect the first circuit pattern 125 and the second circuit pattern 126, the first circuit pattern 125 and the third circuit pattern 127, or the second circuit pattern 126 and the third circuit pattern 127 which are disposed to be partitioned in the base board 121.

The bending contact bar 146 is bent from both sides of the electrical connection bar 145 in an axial direction and inserted into the insertion hole 141 to be in contact with the circuit pattern 125, 126, or 127. For convenience, it is assumed that the bending contact bar 146 is bent downward from the electrical connection bar 145.

In addition, the catch portion 149 is formed on each bending contact bar 146 and is in contact with the circuit pattern 125, 126, or 127 corresponding to an upper edge of the insertion hole 141, thereby maintaining an interval between the electrical connection bar 145 and the main printed circuit board 120.

Since the electrical connection bar 145 corresponding to a portion between the bending contact bars 146 at both sides is spaced apart from the base board 121, heat and electromagnetic waves generated from the electrical connection bar 145 do not affect the electronic components mounted on the base board 121.

Of course, the catch portion 149 may be formed in any one of various shapes.

After the catch portion 149 comes in contact with the circuit pattern 125, 126, or 127, a waterproof liquid is applied on a periphery of each of the bending contact bars 146 and cured, thereby forming the waterproof adhesive layer 150. The bending contact bar 146 and the main printed circuit board 120 are not arbitrarily separated by the waterproof adhesive layer 150 and are waterproofed.

Accordingly, since the jumping busbar 140 made of a conductive material is electrically connected directly to the partitioned circuit patterns 125, 126, and 127 of the main printed circuit board 120 as compared to before, a manufacturing process of the main printed circuit board 120 is simplified, thereby shortening a manufacturing time and reducing manufacturing costs.

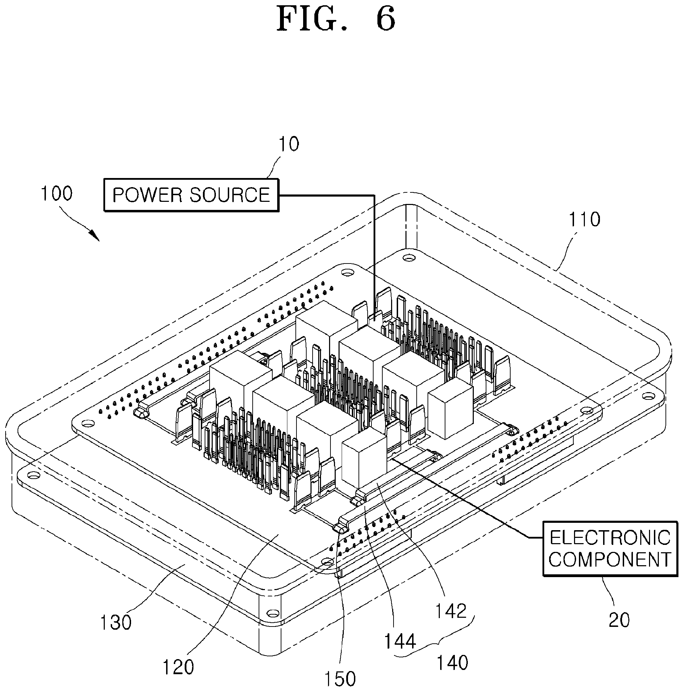

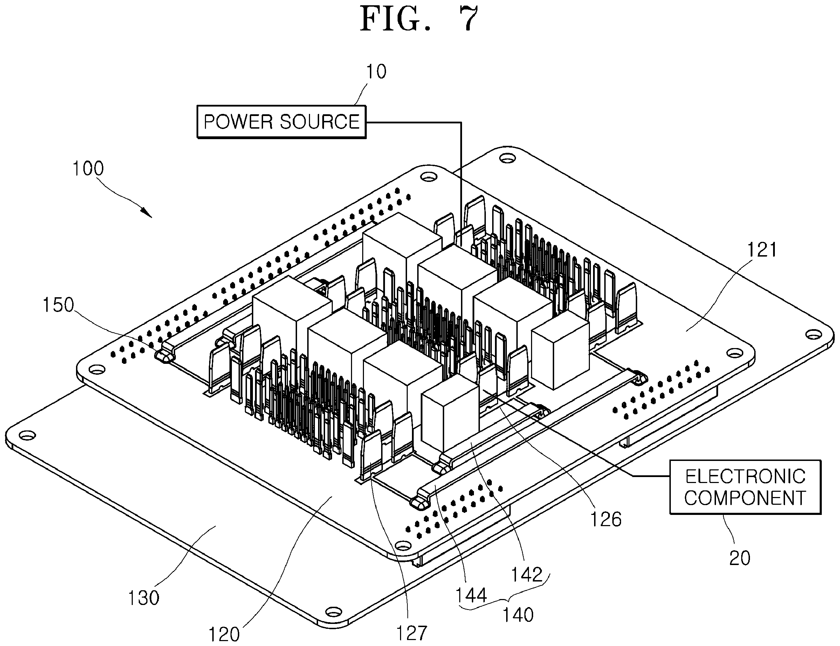

FIG. 6 is a perspective view of a junction block for distributing high-current power according to another embodiment of the present invention. FIG. 7 is a perspective view of a main part of the junction block for distributing high-current power according to another embodiment of the present invention.

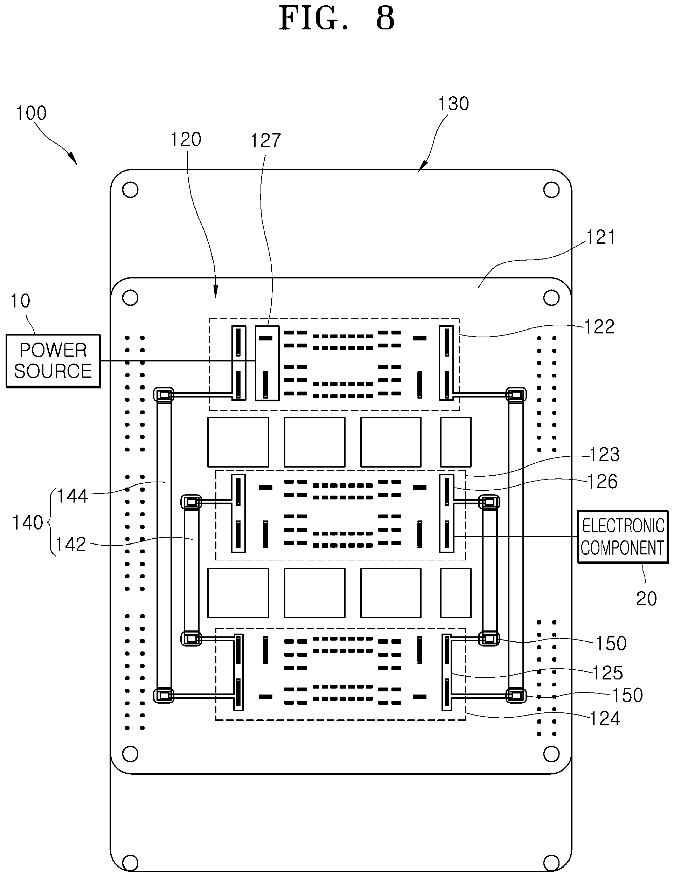

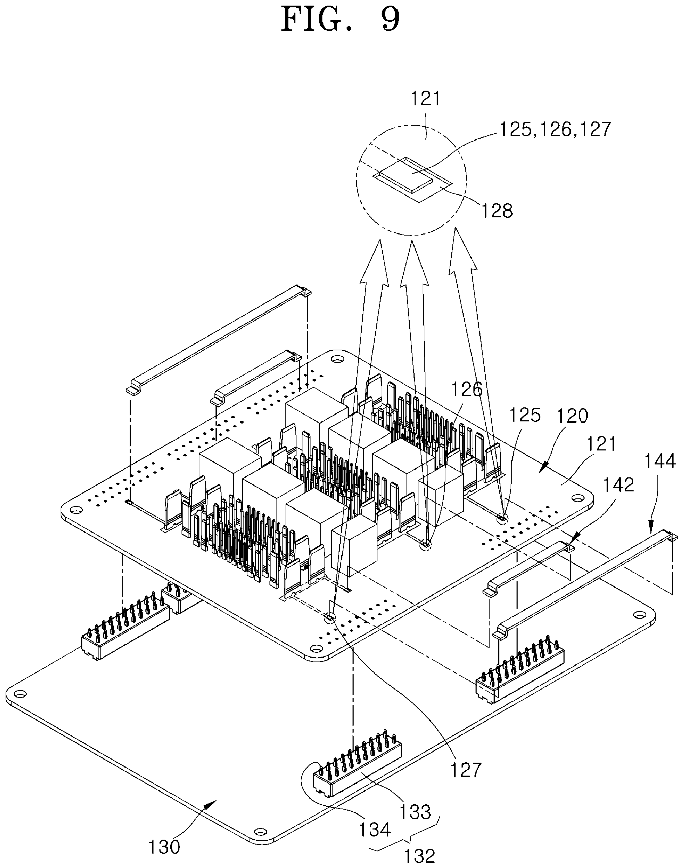

FIG. 8 is a plan view of the junction block for distributing high-current power according to another embodiment of the present invention. FIG. 9 is an exploded perspective view of the main part of the junction block for distributing high-current power according to another embodiment of the present invention.

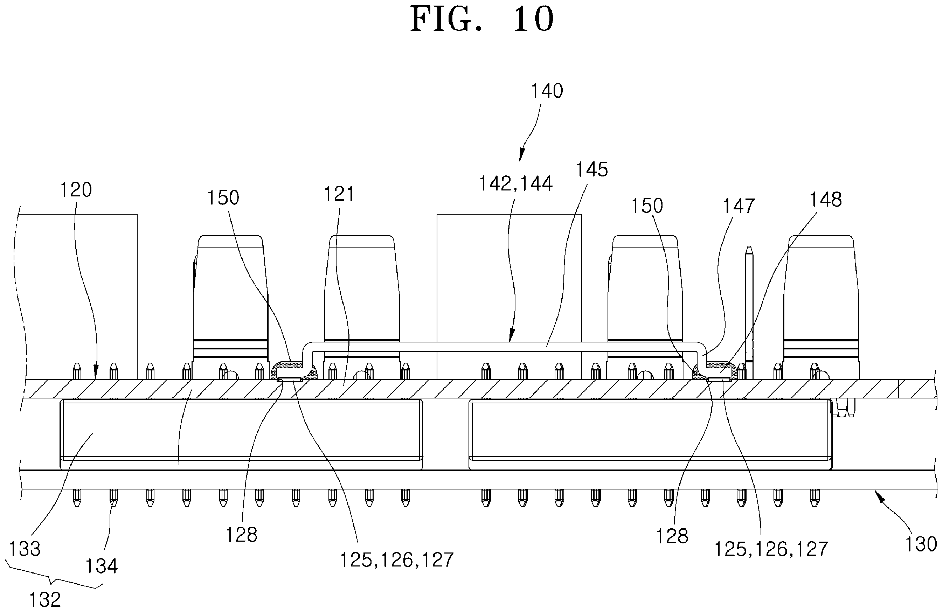

FIG. 10 is a cross-sectional view of the junction block for distributing high-current power according to another embodiment of the present invention.

Referring to FIGS. 6 to 10, a junction block 100 for distributing high-current power according to another embodiment of the present invention includes a main printed circuit board 120, a sub-printed circuit board 130, a jumping busbar 140, and a waterproof adhesive layer 150.

In this case, the main printed circuit board 120, the sub-printed circuit board 130, and the waterproof adhesive layer 150 are the same as those described in the previous embodiment.

As described in the previous embodiment, the jumping busbar 140 is exposed to the outside of the main printed circuit board 120 and serves to electrically connect circuit areas 122, 123, and 124 spaced apart from each other in the main printed circuit board 120.

In addition, as described in the previous embodiment, the jumping busbar 140 may include an inner busbar 142 and an outer busbar 144.

Meanwhile, at least one of the inner busbar 142 and the outer busbar 144 may include an electrical connection bar 145, an edge bending bar 147, and a surface contact bar 148.

For convenience, in the present embodiment, the inner busbar 142 and the outer busbar 144 are illustrated as having the same shape.

As described in the previous embodiment, the electrical connection bar 145 is made of a bar-shaped conductor.

The electrical connection bar 145 may be formed to have a certain length to jump-connect a first circuit pattern 125 and a second circuit pattern 126, the first circuit pattern 125 and a third circuit pattern 127, or the second circuit pattern 126 and the third circuit pattern 127 which are disposed to be partitioned in a base board 121.

In addition, the edge bending bar 147 is bent from both sides of the electrical connection bars 145 in an axial direction. It is assumed that the edge bending bar 147 is bent downward from the electrical connection bar 145.

In addition, the surface contact bar 148 is bent to be parallel to the main printed circuit board 120 at each edge bending bar 147 and is in surface contact with the circuit pattern 125, 126, or 127.

Since the electrical connection bar 145 corresponding to a portion between the edge bending bars 147 at both sides is spaced apart from the base board 121, heat and electromagnetic waves generated from the electrical connection bar 145 do not affect electronic components mounted on the base board 121.

After the surface contact bar 148 comes in surface contact with the circuit pattern 125, 126, or 127, a waterproofing liquid is applied on a periphery of each surface contact bar 148 and cured, thereby forming the waterproof adhesive layer 150. The surface contact bar 148 and the main printed circuit board 120 are not arbitrarily separated by the waterproof adhesive layer 150 and are waterproofed.

Undescribed reference symbols are the same as those described in the previous embodiment.

As described above, in a junction block for distributing high-current power of the present invention, unlike a related art, different circuit areas of a printed circuit board are jump-power-connected with a jumping busbar exposed from the printed circuit board to allow a flow of high current and increase heat dissipation efficiency through the exposed jumping busbar, and eliminate a need for a separate component other than the jumping busbar for jump power connection, thereby improving the assemblability of the printed circuit board assembly and reducing manufacturing costs.

The present invention has been described with reference to embodiments shown in the drawings, but this is merely illustrative, and those skilled in the art will understand that various modifications and other equivalent embodiments are possible therefrom.

Therefore, the true technical protection scope of the present invention should be defined by the appended claims.

## Claims

1. A junction block for distributing high-current power, the junction block comprising:
a main printed circuit board;
a jumping busbar exposed to the outside of the main printed circuit board and configured to electrically connect circuit areas spaced apart from each other in the main printed circuit board; and
a waterproof adhesive layer which is applied on an area in which the jumping busbar and the main printed circuit board are in contact and cured, maintains contact between the jumping busbar and the circuit area, and serves as a waterproofing layer.

2. The junction block of claim 1, wherein the main printed circuit board electrically connects a sub-printed circuit board disposed to face the main printed circuit board.

3. The junction block of claim 1, wherein the main printed circuit board includes:
a first circuit area which receives power from the outside and in which a first circuit pattern is patterned;
a second circuit area which is spaced apart from the first circuit area and receives power to control a voltage and a current according to set capacity and then transmit and guide the voltage and current to the outside and in which a second circuit pattern is patterned; and
a third circuit area which is spaced apart from the first circuit area and the second circuit area and receives power from the first circuit area or the second circuit area to supply the power to a mounted electronic element and in which a third circuit pattern is patterned,
wherein the second circuit area receives power from the first circuit area or the third circuit area.

4. The junction block of claim 3, wherein the jumping busbar includes:
an inner busbar configured to jump-connect the first circuit pattern and the second circuit pattern; and
an outer busbar configured to jump-connect the first circuit pattern and the third circuit pattern or the second circuit pattern and the third circuit pattern.

5. The junction block of claim 4, wherein the main printed circuit board has exposure grooves formed to expose portions of the first circuit pattern, the second circuit pattern, and the third circuit pattern which are embedded and patterned,
the inner busbar is in contact with the first circuit pattern and the second circuit pattern through the exposure grooves, and
the outer busbar is in contact with the first circuit pattern and the third circuit pattern or the second circuit pattern and the third circuit pattern through the exposure grooves.

6. The junction block of claim 5, wherein an insertion hole is formed to pass through the main printed circuit board and a corresponding circuit pattern, and
at least one of the inner busbar and the outer busbar includes an electrical connection bar made of a bar-shaped conductor, a bending contact bar bent from both sides of the electrical connection bar in an axial direction and inserted into the insertion hole to be in contact with the corresponding circuit pattern, and a catch portion formed on the bending contact bar and in contact with the circuit pattern corresponding to an upper edge of the insertion hole to maintain an interval between the electrical connection bar and the main printed circuit board.

7. The junction block of claim 5, wherein at least one of the inner busbar and the outer busbar includes:
an electrical connection bar made of a bar-shaped conductor;
edge bending bars bent from both sides of the electrical connection bar in an axial direction; and
a surface contact bar bent form each edge bending bar to be parallel to the main printed circuit board and in surface contact with the circuit pattern.
